**Europäisches Patentamt**

**European Patent Office**

**Office européen des brevets**

(19)

(11) Veröffentlichungsnummer: **0 217 071**
**B1**

(12) **EUROPÄISCHE PATENTSCHRIFT**

(45) Veröffentlichungstag der Patentschrift:
23.11.89

(51) Int. Cl.⁴: **C25F 3/14, C23F 1/02**

(21) Anmeldenummer: **86110872.8**

(22) Anmeldetag: **06.08.86**

(54) **Verfahren zur Erzeugung von Strukturen in der Mikromechanik.**

(30) Priorität: **30.09.85 DE 3534860**

(43) Veröffentlichungstag der Anmeldung:
**08.04.87 Patentblatt 87/15**

(45) Bekanntmachung des Hinweises auf die Patenterteilung:
**23.11.89 Patentblatt 89/47**

(84) Benannte Vertragsstaaten:
**DE FR GB IT NL SE**

(56) Entgegenhaltungen:
**CHEMICAL ABSTRACTS, Band 99, Nr. 8, 22.
August 1983, Seite 226, Zusammenfassung Nr. 57518y,
Columbus, Ohio, US; & JP-A-58 07 706 (MATSUSHITA
ELECTRIC INDUSTRIAL CO. LTD.) 10-02-1983**

(73) Patentinhaber: **Siemens Aktiengesellschaft,
Wittelsbacherplatz 2, D-8000 München 2(DE)**

(72) Erfinder: **Ehrler, Günter, Dipl.-Phys., Linienstrasse 25a,
D-8024 Deisenhofen(DE)**
Erfinder: **Hagen, Heinz, Dipl.-Ing.,
Albrecht-Dürer-Strasse 32, D-8014 Neubiberg(DE)**
Erfinder: **Becker, Klaus, Dipl.-Ing., Balanstrasse 69,
D-8000 München 90(DE)**

## Beschreibung

Verfahren zur Erzeugung von Strukturen in der Mikromechanik

Die Erfindung betrifft ein Verfahren zur Erzeugung von Strukturen auf einem Festkörper in der Mikromechanik nach dem Oberbegriff des Anspruchs 1. Ein solches Verfahren ist aus Chemical Abstracts, Band 99, Nr. 57518 y bekannt.

Soll in der Mikromechanik ein Festkörper strukturiert werden, dessen Strukturenunterschiedliche Dicken bzw. unterschiedliche Tiefen aufweisen sollen, so werden diese Strukturen bisher nur mit mechanischen Verfahren wie z.B. durch Bohren, Fräsen, Funkenerodieren usw. erzeugt.

In der Halbleitertechnologie werden mit Fotolithografie-Standardprozessen üblicherweise auf der Oberfläche eines Halbleiters Strukturen mit einer Tiefe zwischen etwa 0,1 µm und 1 µm erzeugt. Da die Dicke des verwendeten Fotolacks in der Größenordnung 1 µm bis 4 µm liegt, können in der Halbleitertechnologie beliebig viele fotolithografische Strukturierungsschtitte hintereinander erfolgen, ohne daß die bei vorher gehenden fotolithografischen Strukturierungsschritten in der Oberfläche des Halbleiters bereits erzeugten Strukturen dabei hinderlich wären.

Diese in der Halbleitertechnologie üblichen Fotolithografie-Standardprozesse lassen sich auf die Mikromechanik nicht ohne weiteres übertragen, weil in der Mikromechanik in einem Festkörper Strukturen bis zu einer Tiefe von 500 µm und mehr benötigt werden. Mehrere hintereinander erfolgende Strukturierungsschritte, wie sie in der Halbleitertechnologie bei Fotolithografie-Standardprozessen üblich sind, lassen sich in der Mikromechanik mittels einer Fototechnik nicht durchführen. Schon zwei hintereinander erfolgende Strukturierungsschritte jeweils mittels einer Fototechnik sind in der Mikromechanik nicht möglich.

In der eingangs genannten Veröffentlichung Chemical Abstracts, Band 99, Nr. 57518 y ist das Ätzen von Metall mit Hilfe von Lackschichten beschrieben. Metall läßt sich wesentlich einfacher ätzen als ein Halbleiter-Festkörper. Die bloße Verwendung zweier Lackmasken würde die Erzeugung von unterschiedlich tiefen Strukturen, die tiefer als 50 µm sind, nicht zulassen.

Der vorliegenden Erfindung liegt die Aufgabe zugrunde, ein Verfahren der eingangs genannten Art anzugeben, welches die Herstellung von mindestens zwei aufeinanderfolgenden Strukturierungen mit Tiefen, die in der Mikromechanik benötigt werden, ermöglicht.

Diese Aufgabe wird erfindungsgemäß durch ein Verfahren nach dem Anspruch 1 gelöst.

Als Festkörper ist bezüglich dieser Erfindung ein Halbleiter-Festkörper zu verstehen.

Bei einem Verfahren nach der Erfindung werden auf dem Festkörper mindestens zwei unterschiedliche, selektiv entfernbare Ätzmasken hintereinander aufgebracht. Jeweils zwei räumliche übereinander aufgebrachte Ätzmasken müssen dabei selektiv ätzbar sein. Die Zahl der hintereinander auf dem Festkörper aufgebrachten, selektiv entfernbaren Ätzmasken bestimmt die Zahl der möglichen Strukturierungsschritte. Mit mindestens zwei Strukturierungsschritten können im Festkörper Strukturen mit unterschiedlichen Dicken (Tiefen) erzeugt werden.

Selektiv entfernbare Ätzmasken können beispielsweise erstens aus einer Titan-Gold-Schicht und zweitens aus Fotolack bestehen. Eine Titan-Gold-Ätzmaske kann aus einer Titan-Gold-Schicht mit Hilfe einer Fotolackmaske erzeugt werden. Dabei wird zuerst eine Titan-Gold-Schicht aufgebracht, sodann wird auf dieser Titan-Gold-Schicht eine Fotolackmaske erzeugt, sodann wird die Struktur dieser Fotolackmaske durch Ätzen der Titan-Gold-Schicht abgebildet, wodurch aus der Titan-Gold-Schicht die Titan-Gold-Ätzmaske entsteht. Nach Erzeugen dieser Titan-Gold-Ätzmaske wird der dabei als Hilfsmittel verwendete Fotolack wieder entfernt.

Weitere Vorteile und Ausgestaltungen der Erfindung ergeben sich aus den Unteransprüchen, der Beschreibung und der Zeichnung.

Fig. 1 bis 5 erläutern den prinzipiellen technologischen Ablauf eines erfindungsgemäßen Verfahrens.

Fig. 6 und 7 zeigen Bauelemente der Mikromechanik, die mit erfindungsgemäßen Verfahren hergestellt worden sind.

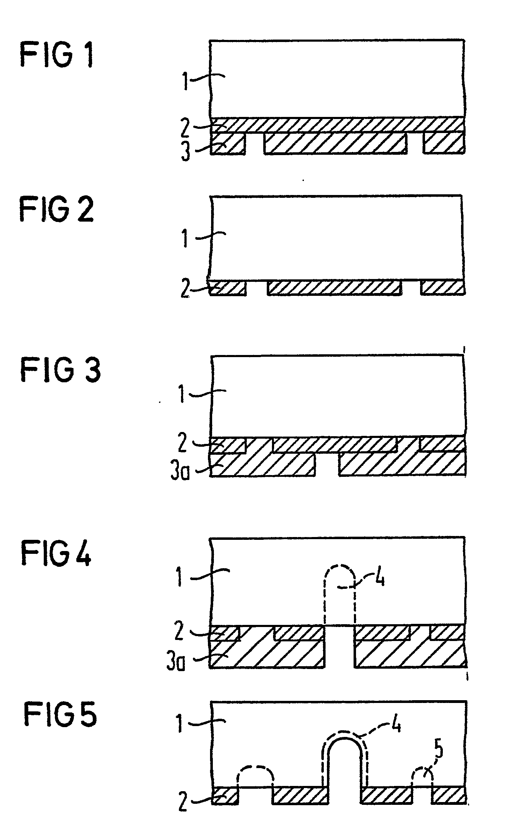

Der prinzipielle technologische Ablauf eines zweistufigen Ätzverfahrens für Anwendungen in der Mikromechanik ist am Ausführungsbeispiel nach den Fig. 1 bis 5 dargestellt.

Fig. 1 zeigt als Festkörper einen Siliciumwafer 1, der ganzflächig mit einer Titan-Gold-Schicht 2 bedampft worden ist. Auf die Titan-Gold-Schicht 2 ist eine Fotolackschicht 3 aufgebracht worden, die nach dem Fachmann bekannten Fotolithografie-Standardprozessen strukturiert worden ist.

Fig. 2 zeigt den Siliciumwafer 1 von Fig. 1, nachdem die in der Fotolackschicht 3 erzeugte Struktur durch Ätzen der Titan-Gold-Schicht 2 auf diese Titan-Gold-Schicht 2 abgebildet worden ist, wodurch eine erste Ätzmaske aus Titan-Gold entstanden ist, und nachdem der verbliebene Fotolack der Fotolackschicht 3 entfernt worden ist. Die erste Ätzmaske ist also aus der Titan-Gold-Schicht 2 durch Strukturierung der Titan-Gold-Schicht 2 erzeugt worden. Die Strukturierung der Titan-Gold-Schicht 2 muß nicht notwendig mit Hilfe einer Fotolackschicht 3 erfolgen. Auch muß die erste Ätzmaske nicht notwendig aus Titan-Gold bestehen. Die erste Ätzmaske kann aus jedem Material bestehen, das selektiv im Vergleich zur zweiten Ätzmaske entfernbar ist. Die erste Ätzmaske kann auch mit jedem Verfahren erzeugt werden, mit denen eine strukturierte Ätzmaske hergestellt werden kann.

Fig. 3 zeigt den Siliciumwafer 1 von Fig. 2 mit der ersten Ätzmaske 2 auf dem Siliciumwafer 1 und mit einer neuen Fotolackschicht 3 a, die auf das Gebilde von Fig. 2 bestehend aus Siliciumwafer 1 und erster Ätzmaske 2 aufgebracht und sodann strukturiert worden ist. Die Fotolackschicht 3 a ist im Vergleich zur Titan-Gold-Schicht 2 selektiv ätzbar.

Fig. 4 zeigt das Gebilde von Fig. 3, bei dem auf den Siliciumwafer 1 eine erste Ätzmaske 2 und darauf eine zweite Ätzmaske 3 a aufgebracht worden sind, bei dem in den Öffnungen der zweiten Ätzmaske 3 a die darunterliegende Titan-Gold-Schicht der ersten Ätzmaske 2 geätzt worden ist und bei dem anschließend durch Ätzen des Siliciumwafers 1 in einem ersten Strukturierungsschritt zur Strukturierung des Siliciumwafers 1 ein durchgehendes Loch 4 vorgeätzt wird. Beim ersten Strukturierungsschritt zur Strukturierung des Siliciumwafers 1 kann das Loch 4 bis zu einer Tiefe von etwa 300 µm vorgeätzt werden.

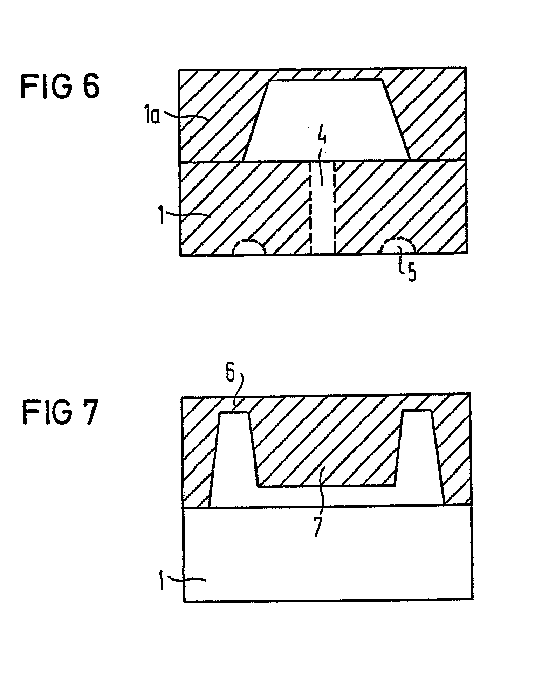

Fig. 5 zeigt das Gebilde von Fig. 4, nachdem die zweite Ätzmaske 3 a entfernt worden ist, und nachdem in den Öffnungen der ersten Ätzmaske 2 in einem zweiten Strukturierungsschritt zur Strukturierung des Siliciumwafers 1 weitere Teile des Siliciumwafers 1 sowohl im Loch 4 als auch in den Vertiefungen 5 weggeätzt worden sind.

Im Ausführungsbeispiel nach den Fig. 1 bis 5 ist die Herstellung einer Trägerscheibe für einen Relativdrucksensor veranschaulicht. Im ersten Strukturierungsschritt zur Strukturierung des Siliciumwafers 1 wird ein durchgehendes Loch 4 vorgeätzt bis zu einer Tiefe von etwa 300 µm, im zweiten Strukturierungsschritt zur Strukturierung des Siliciumwafers 1 wird dieses Loch 4 durchgeätzt bis zu einer Tiefe von etwa 400 µm und wird eine Ringnut 5 mit einer Tiefe von etwa 100 µm um dieses Loch 4 geätzt.

Fig. 6 zeigt einen Schnitt durch einen Relativdrucksensor, der aus dem Siliciumwafer 1 und aus einem weiteren Siliciumwafer 1 a besteht. Der Siliciumwafer 1 besitzt das durchgehende Loch 4 und die Ringnut 5.

Fig. 7 zeigt einen weiteren Anwendungsfall für das zweistufige Ätzverfahren in der Mikromechanik. Fig. 7 verdeutlicht das doppelt-strukturierte Ätzen einer Ringmembran 6. Im ersten Ätzschritt, der dem in Fig. 4 gezeigten ersten Strukturierungsschritt des Siliciumwafers 1 entspricht, wird die Vorätzung der Ringmembran 6 vorgenommen. Im zweiten Ätzschritt, der dem zweiten Strukturierungsschritt des Siliciumwafers 1 nach Fig. 5 entspricht, wird die Feinätzung bis zur Enddicke der Ringmembran 6 zusammen mit der durch Ätzen erfolgenden Verdünnung der Mittelinsel 7 vorgenommen. In dem speziellen Fall von Fig. 7 besteht der zweite Ätzschritt (zweiter Strukturierungsschritt des Siliciumwafers) aus einem elektrochemischen Feinätzverfahren mit automatischem Ätzstop. Das Abätzen der Mittelinsel 7 ist notwendig, um die freie Beweglichkeit der Ringmembran 6 zu ermöglichen.

Zu demjenigen Bauteil von Fig. 7, das die Ringmembran 6 und die Mittelinsel 7 aufweist, gehört ebenso wie in Fig. 6 eine Trägerscheibe 1, die wegen der besseren Übersicht in der Fig. 7 nicht in näheren Einzelheiten dargestellt ist. Die Trägerscheibe 1 wird jedoch auch bei dem Drucksensor nach Fig. 7 ähnlich strukturiert wie bei dem Drucksensor nach Fig. 6.

Um das Prinzip des zweistufigen Ätzverfahrens darzustellen, sind die Schichtdicken in den Fig. 1 bis 5 nicht maßstäblich im Vergleich zur Dicke des Siliciumwafers 1 dargestellt. Die Schichten 2, 3, 3 a können zweckmäßige Dicken aufweisen. Insbesondere können die Ätzmasken 2, 3, 3 a Dicken zwischen 0,1 µm und 10 µm aufweisen. Verschiedene Ätzmasken können zeitlich nacheinander und räumlich übereinander strukturiert werden. Durch das Strukturieren von mindestens zwei Ätzmasken können unterschiedlich tiefe Strukturen im Siliciumwafer 1 oder in einem anderen Festkörper erzeugt werden. Diese unterschiedlich tiefen Strukturen können dabei insbesondere tiefer als 50 µm sein, wobei unterschiedlich tiefe Strukturen in ihren Tiefen Differenzen von insbesondere mehr als 200 µm aufweisen.

## Bezugszeichenliste

1, 1 a Siliciumwafer
2 Titan-Gold-Schicht (erste Äzmaske)
3 Fotolackschicht
3 a Fotolackschicht (zweite Ätzmaske)
4 Loch
5 Vertiefungen (Ringnut)
6 Ringmembran
7 Mittelinse
I

## Patentansprüche

1. Verfahren zur Erzeugung von Strukturen auf einem Festkörper (1), bei dem mindestens zwei unterschiedliche, selektiv entfernbare Ätzmasken (2, 3a) hintereinander auf dem Festkörper (1) aufgebracht werden, bei dem nach Erzeugung der letzten Ätzmaske (3a) ein erster Strukturierungsschritt erfolgt, und bei dem nach Entfernen der letzten Ätzmaske (3a) mit Hilfe der dann auf dem Festkörper (1) verbleibenden Ätzmasken (2) ein weiterer Strukturierungsschritt erfolgt, wobei Enfernen einer weiteren Ätzmaske und Erzeugung eines weiteren Strukturierungsschritts so lange wiederholt werden, bis so viele Strukturierungsschritte durchgeführt worden sind, wie ursprünglich Ätzmasken auf dem Festkörper (1) vorhanden gewesen sind dadurch gekennzeichnet, daß zur Erzeugung von unterschiedlich tiefen Strukturen, die tiefer als 50 µm sind, in der Mikromechanik auf einem Halbleiter-Festkörper (1) die unmittelbar auf dem Halbleiter-Festkörper (1) aufgebrachte Ätzmaske (2) aus Titan-Gold besteht.

2. Verfahren nach Anspruch 1, dadurch gekennzeichnet, daß wenigstens jeweils zwei unmittelbar räumlich übereinander angeordnete Ätzmasken (2, 3 a) selektiv entfernbar sind.

3. Verfahren nach Anspruch 1, dadurch gekennzeichnet, daß zwei unterschiedliche, selektiv entfernbare Ätzmasken (2, 3a) hintereinander auf dem Festkörper (1) aufgebracht werden, daß nach Erzeugung der zweiten Ätzmaske (3a) ein erster Strukturierungsschritt erfolgt, und daß nach Entfernen der zweiten Ätzmaske (3a) mit Hilfe der dann auf dem Festkörper (1) verbleibenden ersten Ätzmaske (2) ein zweiter Strukturierungsschritte erfolgt.

4. Verfahren nach einem der Ansprüche 1 bis 3, dadurch gekennzeichnet, daß eine Ätzmaske (3a) aus Fotolack besteht.

5. Verfahren nach einem der Ansprüche 1 bis 4, dadurch gekennzeichnet, daß die erste Ätzmaske (2) mit Hilfe einer Fotolackmaske (3) strukturiert wird, die nach Strukturierung der ersten Ätzmaske (2) wieder entfernt wird.

6. Verfahren nach einem der Ansprüche 1 bis 5 dadurch gekennzeichnet, daß beim ersten Strukturierungsschritt ein durchgehendes Loch (4) im Festkörper (1) vorgeätzt und daß beim zweiten Strukturierungsschritt das durchgehende Loch (4) durchgeätzt und eine Ringnut (5) um das durchgehende Loch (4) geätzt wird.

7. Verfahren nach einem der Ansprüche 1 bis 6, dadurch gekennzeichnet, daß beim ersten Strukturierungsschritt im Festkörper (1) eine Ringmembran (6) vorgeätzt und daß beim zweiten Strukturierungsschritt die Ringmembran (6) bis zur Enddicke geätzt und eine Mittelinsel (7) innerhalb der Ringmembran (6) verdünnt wird.

8. Verfahren nach einem der Ansprüche 1 bis 7, dadurch gekennzeichnet, daß ein elektrochemisches Feinätzverfahren mit automstischem Ätzstop verwendet wird.

## Claim

1. Process for producing structures on a solid (1), in which at least two different, selectively removable etching masks (2, 3a) are applied one after the other to the solid (1), in which a first structuring step takes place after generation of the last etching mask (3a), and in which a further structuring step takes place after removing the last etching mask (3a) with the aid of the etching masks (2) then remaining on the solid (1), removal of a further etching mask and generation of a further structuring step being repeated until as many structuring steps as there were originally etching masks on the solid (1) have been carried out, characterized in that, for the generation of structures of different depths which are deeper than 50 μm, the etching mask (2) which in micromechanics on a semiconductor solid (1) is applied directly to the semiconductor solid (1) consists of titanium-gold.

2. Process according to Claim 1, characterized in that at least two etching masks (2, 3a), arranged directly one on top of the other, in each case are selectively removable.

3. Process according to Claim 1, characterized in that two different, selectively removable etching masks (2, 3a) are applied one after the other to the solid (1), in that a first structuring step takes place after generation of the second etching mask (3a), and in that a second structuring step takes place after removing the second etching mask (3a) with the aid of the first etching mask (2) then remaining on the solid (1).

4. Process according to one of Claims 1 to 3, characterized in that one etching mask (3a) consists of photoresist.

5. Process according to one of Claims 1 to 4, characterized in that the first etching mask (2) is structured with the aid of a photoresist mask (3), which is removed again after structuring of the first etching mask (2).

6. Process according to one of Claims 1 to 5, characterized in that, during the first structuring step, a through-hole (4) is pre-etched in the solid (1) and in that, in the second structuring step, the through-hole (4) is etched through and an annular groove (5) is etched around the through-hole (4).

7. Process according to one of Claims 1 to 6, characterized in that, in the first structuring step, an annular membrane (6) is pre-etched in the solid (1) and in that, in the second structuring step, the annular membrane (6) is etched to the final thickness and a central island (7) within the annular membrane (6) is thinned.

8. Process according to one of Claims 1 to 7, characterized in that an electrochemical fine etching process with automatic etching resist is used.

## Revendications

1. Procédé pour fabriquer des structures sur un corps solide (1), selon lequel on dépose successivement, sur le corps solide (1), au moins deux masques de corrosion différents (2, 3a), pouvant être éliminés façon sélective, on exécute une première étape de structuration après la production du dernier masque de corrosion (3a) et, après élimination de ce dernier masque de corrosion (3a), on exécute une étape supplémentaire de structuration à l'aide du masque de corrosion (2) qui subsiste sur le corps solide (1), l'élimination d'un autre masque de corrosion et la mise en œuvre d'une autre étape de structuration se répétant jusqu'à ce qu'aient été mises en œuvre autant d'étapes de structuration qu'il y avait, au départ, de masques de corrosion sur le corps solide (1), caractérisé par le fait que pour la production, en micromécanique, de structures possédant des profondeurs différentes, d'une valeur supérieure à 50 μm, sur un corps solide semiconducteur (1), le masque de corrosion (2), déposé directement sur ce corps solide semiconducteur (1), est constitué par du titane-or.

2. Procédé suivant la revendication 1, caractérisé par le fait qu'au moins deux masques respectifs de corrosion (2, 3a), superposés directement dans l'espace, peuvent être éliminés de façon sélective.

3. Procédé suivant la revendication 1, caractérisé par le fait qu'on dépose successivement, sur le corps solide (1), deux masques de corrosion différents (2, 3a), pouvant être éliminés de façon sélective, qu'une première étape de structuration est mise en œuvre après la production du second masque de corrosion (3a) et qu' après l'élimination du second masque (3a), une seconde étape de structuration est mise en œuvre à l'aide du premier masque de corrosion (2) subsistant sur le corps solide (1).

4. Procédé suivant l'une des revendications 1 à 3, caractérisé par le fait qu'un masque de corrosion (3a) est constitué par une laque photosensible.

5. Procédé suivant l'une des revendications 1 à 4, caractérisé par le fait que le premier masque de corrosion (2) est structuré à l'aide un masque de laque photosensible (3), qu'on élimine à nouveau après la structuration du premier masque de corrosion (2).

6. Procédé suivant une des revendications 1 à 5, caractérisé par le fait que, lors de la première étape de structuration, on préforme par corrosion un trou traversant (4) dans le corps solide (1) et que, lors de la seconde étape de structuration, on dégage complètement par corrosion le trou traversant (4) et on ménage par corrosion une gorge annulaire (5) autour du trou traversant (4).

7. Procédé, suivant l'une des revendications 1 à 6, caractérisé par le fait que, lors de la première étape de structuration, on préforme par corrosion une membrane annulaire (6) dans le corps solide (1) et que, lors de la seconde étape de structuration, on corrode la membrane annulaire (6) pour lui donner son épaisseur finale et on amincit un îlot central (7), situé à l'intérieur de la membrane annulaire (6).

8. Procédé suivant une des revendications 1 à 7, caractérisé par le fait qu'on utilise un procédé de corrosion électrochimique fine avec un arrêt automatique de la corrosion.

EP 0 217 071 B1

FIG 1

1

2
3

FIG 2

1

2

FIG 3

1

2
3a

FIG 4

1
4

2
3a

FIG 5

1
4

5

2

**FIG 6**

1a

4

1

5

**FIG 7**

6

7

1